# EUROPÄISCHE PATENTSCHRIFT

(11) **EP 3 017 464 B1**
(45) Veröffentlichungstag und Bekanntmachung des Hinweises auf die Patenterteilung: **08.01.2020**
(21) Anmeldenummer: 14747849.9
(22) Anmeldetag: 30.06.2014
(51) Int. Cl.: H01L 23/10, H01L 21/48, H01L 23/00, H01L 51/44, H01L 51/52, H01L 51/56

(54) **OPTOELEKTRONISCHES BAUELEMENT UND VERFAHREN ZU SEINER HERSTELLUNG**
OPTOELECTRONIC DEVICE AND ITS MANUFACTURING METHOD
DISPOSITIF OPTO-ÉLECTRONIQUE ET SA MÉTHODE DE FABRICATION

(30) Priorität: 02.07.2013 DE 102013106937
(43) Veröffentlichungstag der Anmeldung: 11.05.2016
(73) Patentinhaber: OSRAM OLED GmbH, 93049 Regensburg (DE)
(72) Erfinder: BAISL, Richard, 93053 Regensburg (DE); KEFES, Christoph, 93049 Regensburg (DE); POPP, Michael, 85354 Freising (DE)
(74) Vertreter: Viering, Jentschura & Partner mbB Patent- und Rechtsanwälte
(86) Internationale Anmeldenummer: PCT/EP2014/063868
(87) Internationale Veröffentlichungsnummer: WO 2015/000857

(56) Entgegenhaltungen:
- DE-A1- 19 532 251
- DE-A1-102007 046 730
- DE-A1-102011 084 276
- DE-A1-102011 086 689
- US-A- 3 141 238
- US-A- 3 335 489
- US-A- 5 043 139
- US-A- 5 053 195
- US-A- 5 653 856
- US-A1- 2003 215 981

## Beschreibung

Die Erfindung betrifft ein Verfahren zum Herstellen eines optoelektronischen Bauelements und ein optoelektronisches Bauelement.

Bei einem herkömmlichen optoelektronischen Bauelement werden zum Verbinden und/oder Abdichten von Komponenten des optoelektronischen Bauelements, Haftmittel, beispielsweise Klebstoffe, Lote, Verkapselungsschichten, Metalldichtungen und/oder Abdeckkörper, wie beispielsweise Glaskörper, verwendet. Das Aufbringen dieser Hilfsmittel auf die zu verbindenden bzw. abzudichtenden Komponenten des optoelektronischen Bauelements kann häufig relativ zeitaufwendig, kostenintensiv und/oder unpräzise sein. Beim Trocknen und/oder bei Temperaturwechselbelastungen von Haftmitteln und/oder Verkapselungsschichten können Risse oder Löcher in den entsprechenden Schichten auftreten. Ferner können beim Herstellen der entsprechenden optoelektronischen Bauelemente Partikel in die Schichten oder zwischen die Schichten geraten. Diese Risse, Löcher und/oder Partikel können dazu führen, dass das entsprechende optoelektronische Bauelement nur noch eingeschränkt oder gar nicht mehr funktioniert.

Aus dem Stand der Technik ist Dokument DE10 2011 084 276-A1 bekannt, welches eine Verkapselung für ein organisches elektronisches Bauelement beschreibt mit folgenden Schichten: eine Dünnschichtverkapselung, eine erste Klebstoffschicht, die zumindest ein Gettermaterial umfasst und eine Deckschicht.

Insbesondere bei optoelektronischen Flächenlichtquellen, wie beispielsweise OLEDs ist die hermetische Abschirmung organisch funktioneller Schichtenstrukturen wichtig, um beispielsweise die Lagerbeständigkeit, beispielsweise 10 Jahre, und/oder die Lebensdauer im Betrieb, beispielsweise über 10000 Stunden, zu gewährleisten. Hierbei können beispielsweise Permeabilitätswerte für Feuchtigkeit und/oder Sauerstoff kleiner 10⁻⁶g/cm/d gefordert werden. Bekannte Mittel zum Abdichten und/oder Verkapseln der optoelektronischen Bauelemente sind u.a. sehr empfindlich bezüglich Partikelbelastung und bekannte Prozesse können sogar die Lebensdauer reduzieren, zugunsten längerer Lagerzeiten. Daher werden bei bekannten Verfahren TFE-Dünnfilmverkapselungen unter sehr sauberer Atmosphäre mit minimalster Partikelbelastung hergestellt, beispielsweise in einem TFE-Prozess ohne Schattenmaske. Die TFE-Verkapselung kann beispielsweise eine CVD-, ALD-, PECUP-Schicht oder eine andere Schicht sein. Alternativ dazu werden auch andere Verkapselungsmethoden angewandt, beispielsweise die Cavityverkapselung und die Glaslotverkapselung.

In verschiedenen Ausführungsformen wird ein Verfahren zum Herstellen eines optoelektronischen Bauelements bereitgestellt, das ermöglicht, das optoelektronische Bauelement einfach, günstig und/oder präzise herzustellen, und/oder Komponenten des optoelektronischen Bauelements einfach, kostengünstig und/oder präzise zu verkapseln und/oder abzudichten.

In verschiedenen Ausführungsformen wird ein optoelektronisches Bauelement bereitgestellt, das einfach, günstig und/oder präzise herstellbar ist, und/oder dessen Komponenten einfach, kostengünstig und/oder präzise verkapselt und/oder abgedichtet sind.

In verschiedenen Ausführungsformen wird ein Verfahren zum Herstellen eines optoelektronischen Bauelements bereitgestellt, bei dem eine optoelektronische Schichtenstruktur mit einer funktionellen Schichtenstruktur über einem Träger ausgebildet wird. Eine Rahmenstruktur, die ein erstes metallisches Material aufweist, wird auf der optoelektronischen Schichtenstruktur so ausgebildet, dass ein Bereich über der funktionellen Schichtenstruktur frei von der Rahmenstruktur ist und dass die Rahmenstruktur den Bereich umgibt. Eine Haftschicht, die ein zweites metallisches Material aufweist, wird über einem Abdeckkörper ausgebildet. Eine flüssige erste Legierung, deren Schmelzpunkt in einem Bereich zwischen -20° C und 100° C liegt, wird in dem Bereich auf die erste optoelektronische Schichtenstruktur und/oder auf die Haftschicht des Abdeckkörpers aufgebracht. Der Abdeckkörper wird so mit der optoelektronischen Schichtenstruktur gekoppelt, dass die Haftschicht mit der Rahmenstruktur gekoppelt ist und die flüssige erste Legierung mit der Haftschicht und der Rahmenstruktur in direktem körperlichen Kontakt ist. Zumindest ein Teil der ersten Legierung reagiert mit den metallischen Materialien der Rahmenstruktur und der Haftschicht, beispielsweise chemisch, wodurch mindestens eine zweite Legierung gebildet wird, die erstarrt und so den Abdeckkörper fest mit der optoelektronischen Schichtenstruktur verbindet.

Das Anordnen der flüssigen ersten Legierung in dem Bereich über der funktionellen Schichtenstruktur ermöglicht, das optoelektronische Bauelement einfach, günstig und/oder präzise herzustellen, und die Komponenten des optoelektronischen Bauelements, insbesondere den Abdeckkörper und die optoelektronische Schichtenstruktur, einfach, kostengünstig und/oder präzise zu verkapseln und/oder abzudichten. Der Schmelzpunkt der ersten Legierung ist niedriger als der Schmelzpunkt der zweiten Legierung. Der niedrige Schmelzpunkt der ersten Legierung liegt unter einer Temperatur, ab der Materialien der funktionellen Schichtenstruktur, beispielsweise organischer Schichten, geschädigt werden. Dies ermöglicht eine besonders schonende Herstellung des optoelektronischen Bauelements, wodurch wiederum die Lebensdauer und die Lagerbeständigkeit erhöht werden können.

Durch den Einsatz der niedrig schmelzenden ersten Legierung in Zusammenwirken mit der zweiten oder weiteren Legierungen kann aus der ersten und zweiten Legierung eine metallische Versiegelungsschicht hergestellt werden. Dabei ist die Schmelztemperatur der ersten Legierung so gewählt, dass die erste Legierung unter allen Betriebs- und Lagerbedingungen flüssig ist, und die Schmelztemperatur der zweiten Legierung kann so gewählt sein, dass die zweite Legierung unter allen Betriebs- und Lagerbedingungen fest ist. Die Haftschicht kann eine flüssige Ausgangslegierung aufweisen, die das zweite metallische Material aufweist.

Das Koppeln des Abdeckkörpers mit der optoelektronischen Schichtenstruktur mit Hilfe der flüssigen ersten Legierung findet bei einer Temperatur statt, bei der die erste Legierung flüssig ist und die zweite Legierung nicht flüssig ist. Beim Kontakt mit den metallischen Materialien der Rahmenstruktur und der Haftschicht bildet sich aus den Metallen der ersten Legierung und den metallischen Materialien der Rahmenstruktur und der Haftschicht die zweite Legierung. Diese geht aufgrund der aktuell herrschenden Temperatur in ihren festen Aggregatszustand über und erstarrt. Dabei werden der Abdeckkörper und die optoelektronische Schichtenstruktur miteinander verbunden. Erfolgt dieser Vorgang schlüssig und vollständig um den Bereich über der funktionellen Schichtenstruktur, insbesondere entlang der Rahmenstruktur, so wird dieser Bereich gegenüber der Umgebung abgedichtet, beispielsweise flüssigkeitsdicht und/oder gasdicht.

Falls die erste Legierung an einer Stelle auf die optoelektronische Schichtenstruktur aufgebracht wird, an der die optoelektronische Schichtenstruktur eine Störstelle, beispielsweise einen Riss, ein Loch oder einen Partikel aufweist, so kann die erste Legierung in den Riss oder das Loch fließen und diese verschließen bzw. kann der Partikel in der flüssigen ersten Legierung eingebettet werden. Dies kann dazu beitragen, dass das optoelektronische Bauelement über eine lange Lebensdauer betrieben werden kann und/oder über eine lange Lagerzeit gelagert werden kann, ohne dass die Funktionalität des optoelektronischen Bauelements wesentlich vermindert ist.

Die erste Legierung, die Rahmenstruktur und die Haftschicht können so ausgebildet werden, dass die erste Legierung zumindest in Teilen des Bereichs über der funktionellen Schichtenstruktur flüssig bleibt, auch nach Fertigstellung des optoelektronischen Bauelements. Falls sich dann nachfolgend eine Störstelle bildet, so kann auch bei fertiggestelltem Bauelement die erste Legierung in die Störstelle fließen und diese verschließen.

Falls eine der im Vorhergehenden genannten Störstellen sich bis hin zu einer Schicht der funktionellen Schichtenstruktur erstreckt, die ein metallisches Material aufweist, das mit der ersten Legierung reagiert, so kann sich die zweite oder eine weitere Legierung bilden, die dann erstarrt und die entsprechende Störstelle fest verschließt.

Die erste Legierung kann beispielsweise direkt auf einer Verkapselungsschicht, beispielsweise einer TFE-Schicht, oder auf einer Elektrodenschicht, beispielsweise einer Kathode, des optoelektronischen Bauelement aufgebracht sein. Kommt es zu einem Kontakt mit dem metallischen Material, beispielsweise der Kathodenschicht, so beginnt die Legierungsbildung der zweiten Legierung, die die Störstelle verschließt. Die flüssige erste Legierung kann somit ermöglichen, dass das optoelektronische Bauelement über eine Art von Selbstheilungsmechanismus verfügt. Dadurch kann die Lebensdauer, eine Robustheit und die Lagerbeständigkeit verbessert werden.

Dass die erste Legierung flüssig ist, bedeutet, dass die erste Legierung in flüssigem Aggregatszustand vorliegt. Dies steht im Unterschied zu einer Situation, in der Legierungspartikel zwar in festem Zustand vorliegen, jedoch in einem flüssigen oder zähflüssigen Trägermaterial eingebettet sind, wie beispielsweise Lotkügelchen in einer Lotpaste. Dass mindestens eine zweite oder eine weitere Legierung gebildet wird, bedeutet, dass die flüssige erste Legierung zusammen mit dem ersten, zweiten bzw. weiterem metallischen Material die zweite bzw. die weitere Legierung bildet, wobei die metallischen Materialien untereinander gleich oder unterschiedlich sein können. Falls beispielsweise das erste und das zweite metallische Material gleich sind, so wird genau eine zweite Legierung gebildet. Falls das erste und das zweite metallische Material unterschiedlich sind, so kann die zweite Legierung und eine weitere Legierung, beispielsweise eine dritte Legierung, gebildet werden.

Die Haftschicht kann einstückig mit dem Abdeckkörper ausgebildet sein. In anderen Worten kann die zweite Haftschicht von dem Material des Abdeckkörpers gebildet sein. Beispielsweise kann der Abdeckkörper ein metallhaltiges Glas aufweisen, das das zweite metallische Material aufweist. Alternativ dazu kann die Haftschicht auf dem Abdeckkörper ausgebildet sein. Beispielsweise kann der Abdeckkörper mit der Haftschicht beschichtet sein. Das erste und/oder zweite metallische Material kann beispielsweise ein Metall oder ein Halbmetall sein. Der Abdeckkörper kann beispielsweise Glas oder Metall aufweisen und/oder daraus gebildet sein.

Die Haftschicht, die Rahmenstruktur und/oder gegebenenfalls weitere Schichten, beispielsweise eine Verkapselungsschicht können beispielsweise mittels Vakuumverdampfens, Druckens, Sprühens, Laserstrukturierens oder mittels Rakelns ausgebildet werden. Ferner können die Haftschicht und/oder die Rahmenstruktur als Legierung, beispielsweise als Haft- oder Ausgangslegierung, vorliegen, die beispielsweise zunächst flüssig oder zähflüssig sein kann.

Das im Vorhergehenden erläuterte Verfahren erhöht die Lagerbeständigkeit, indem an Undichtigkeitsstellen, beispielsweise einer Verkapselungsschicht, die erste Legierung eingebracht werden kann. Zudem wird dadurch die Partikelresistenz erhöht. Zudem kann dieses Verfahren dazu dienen, Undichtigkeiten in Verkapselungsschichten nachzuweisen. Ferner können große Flächenbereiche mit der flüssigen ersten Legierung benetzt werden, wodurch u.U. eine bessere Partikelresistenz erzielt werden kann. Als flüssige erste Legierung können ungiftige Materialien gewählt werden. Ferner kann die erste Legierung so gewählt werden, dass sie nicht wasserlöslich ist, wodurch weniger bis keine Kontaminationsprobleme auftreten.

Bei verschiedenen Ausführungsformen liegt der Schmelzpunkt der ersten Legierung in einem Bereich zwischen 0° C und 80° C, insbesondere zwischen 20° C und 30°C. Dies trägt dazu bei, die erste Legierung in flüssigem Zustand zu verarbeiten bei einer Temperatur, die für andere Komponenten des optoelektronischen Bauelements, bei einer OLED beispielsweise für eine organisch funktionelle Schichtenstruktur, unschädlich oder zumindest im Wesentlichen unschädlich ist.

Bei verschiedenen Ausführungsformen ist die erste Legierung bei Raumtemperatur flüssig. Dies ermöglicht, das optoelektronische Bauelement besonders günstig und einfach herzustellen. Insbesondere ist beim Verwenden der ersten Legierung keine Temperierung der Komponenten des optoelektronischen Bauelements nötig. Insbesondere ist eine Verarbeitung unter Umgebungsluft im Reinraum möglich.

Bei verschiedenen Ausführungsformen weist die erste Legierung Gallium, Indium, Zinn, Kupfer, Molybdän, Silber und/oder Bismut auf. Beispielsweise weist die erste Legierung GaInSn oder InBiSn auf.

Bei verschiedenen Ausführungsformen weist das erste und/oder zweite metallische Material Aluminium, Zink, Chrom, Kupfer, Molybdän, Silber, Gold, Nickel, Gallium, Indium und/oder Zinn auf. Beispielsweise können auch mehrere Schichten der genannten Materialien in unterschiedlichen Schichtenfolgen ausgebildet werden. Dementsprechend kann die zweite Legierung oder die weitere Legierung beispielsweise Aluminium, Zinn, Magnesium, Silber, Kupfer, Silber, Gold, Molybdän oder Zink aufweisen.

Bei verschiedenen Ausführungsformen weist die optoelektronische Schichtenstruktur eine Verkapselungsschicht auf und die Rahmenstruktur wird auf der Verkapselungsschicht ausgebildet. Die Verkapselungsschicht kann beispielsweise eine TFE-Dünnfilmverkapselung sein.

Bei verschiedenen Ausführungsformen wird lateral benachbart zu der Rahmenstruktur zumindest abschnittsweise eine erste Antihaftschicht ausgebildet, deren Material nicht mit der ersten Legierung chemisch reagiert und/oder die von der ersten Legierung nicht benetzt wird. Die erste Antihaftschicht kann dazu verwendet werden, die chemische Reaktion zwischen der ersten Legierung und den metallischen Materialien der Haftschicht und/oder der Rahmenstruktur zu beschränken. Beispielsweise können innerhalb der Rahmenstruktur mehrere Abschnitte vorhanden sein, in denen die erste Legierung an die Antihaftschicht grenzt. In diesen Abschnitten bildet sich dann gar keine oder nur wenig zweite Legierung.

Bei verschiedenen Ausführungsformen wird lateral benachbart zu der Haftschicht über dem Abdeckkörper eine zweite Antihaftschicht ausgebildet, deren Material nicht mit der ersten Legierung chemisch reagiert und/oder die von der ersten Legierung nicht benetzt wird. Die zweite Antihaftschicht kann dazu verwendet werden, beim Aufbringen der ersten Legierung auf die Haftschicht ein Fließen der ersten Legierung auf die zweite Haftschicht zu verhindern und die Verteilung der ersten Legierung auf einen ersten Bereich zu beschränken.

In verschiedenen Ausführungsformen wird ein optoelektronisches Bauelement bereitgestellt, beispielsweise das optoelektronische Bauelement, das mit Hilfe des im Vorhergehenden erläuterten Verfahrens hergestellt wird. Das optoelektronische Bauelement weist den Träger und die optoelektronische Schichtenstruktur, die über dem Träger ausgebildet ist und die die funktionelle Schichtenstruktur aufweist, auf. Die Rahmenstruktur weist das erste metallische Material auf und ist über der optoelektronischen Schichtenstruktur ausgebildet. Der Bereich über der funktionellen Schichtenstruktur ist frei von der Rahmenstruktur und die Rahmenstruktur umgibt den Bereich. Der Abdeckkörper weist die Haftschicht auf, die das zweite metallische Material aufweist und die mit der Rahmenstruktur gekoppelt ist. Die flüssige erste Legierung ist in dem Bereich auf der optoelektronischen Schichtenstruktur angeordnet. Die zweite Legierung geht aus der chemischen Reaktion der ersten Legierung mit den metallischen Materialien der Rahmenstruktur und der Haftschicht hervor, wobei die zweite Legierung starr ist und den Abdeckkörper fest mit der optoelektronischen Schichtenstruktur verbindet.

Bei verschiedenen Ausführungsformen liegt der Schmelzpunkt der ersten Legierung in einem Bereich zwischen -20° C und 100° C, insbesondere zwischen 0° C und 80° C, insbesondere zwischen 20° C und 30°C.

Bei verschiedenen Ausführungsformen ist die erste Legierung bei Raumtemperatur flüssig.

Bei verschiedenen Ausführungsformen weist die erste Legierung Gallium, Indium, Zinn und/oder Bismut auf.

Bei verschiedenen Ausführungsformen weist das erste und/oder zweite metallische Material Aluminium, Zink, Chrom, Kupfer, Molybdän, Silber, Gold, Nickel, Gallium, Indium und/oder Zinn auf. Beispielsweise können auch mehrere Schichten der genannten Materialien in unterschiedlichen Schichtenfolgen ausgebildet sein.

Bei verschiedenen Ausführungsformen weist die optoelektronische Schichtenstruktur die Verkapselungsschicht auf und die Rahmenstruktur ist auf der Verkapselungsschicht ausgebildet.

Ausführungsbeispiele der Erfindung sind in den Figuren dargestellt und werden im Folgenden näher erläutert.

Es zeigen
- Figur 1: erste Komponenten eines Ausführungsbeispiels eines optoelektronischen Bauelements in einem ersten Zustand während eines Verfahrens zum Herstellen des optoelektronischen Bauelements;
- Figur 2: die ersten Komponenten des optoelektronischen Bauelements gemäß Figur 1 in einem zweiten Zustand während des Verfahrens zum Herstellen des optoelektronischen Bauelements;
- Figur 3: zweite Komponenten des optoelektronischen Bauelements in einem ersten Zustand während des Verfahrens zum Herstellen des optoelektronischen Bauelements;
- Figur 4: die zweiten Komponenten des optoelektronischen Bauelements gemäß Figur 3 in einem zweiten Zustand während des Verfahrens zum Herstellen des optoelektronischen Bauelements;
- Figur 5: das optoelektronische Bauelement gemäß den Figuren 1 bis 4;
- Figur 6: ein Ausführungsbeispiel eines optoelektronischen Bauelements;
- Figur 7: eine Detailansicht eines Ausführungsbeispiels eines optoelektronischen Bauelements;
- Figur 8: eine Detailansicht eines Ausführungsbeispiels eines optoelektronischen Bauelements.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Ein optoelektronisches Bauelement kann in verschiedenen Ausführungsbeispielen ein elektromagnetische Strahlung emittierendes Bauelement oder ein elektromagnetische Strahlung absorbierendes Bauelement sein. Ein elektromagnetische Strahlung absorbierendes Bauelement kann beispielsweise eine Solarzelle sein. Ein elektromagnetische Strahlung emittierendes Bauelement kann beispielsweise ein elektromagnetische Strahlung emittierendes HalbleiterBauelement sein und/oder als eine elektromagnetische Strahlung emittierende Diode, als eine organische elektromagnetische Strahlung emittierende Diode, als ein elektromagnetische Strahlung emittierender Transistor oder als ein organischer elektromagnetische Strahlung emittierender Transistor ausgebildet sein. Die Strahlung kann beispielsweise Licht im sichtbaren Bereich, UV-Licht und/oder Infrarot-Licht sein. In diesem Zusammenhang kann das elektromagnetische Strahlung emittierende Bauelement beispielsweise als Licht emittierende Diode (light emitting diode, LED) als organische Licht emittierende Diode (organic light emitting diode, OLED), als Licht emittierender Transistor oder als organischer Licht emittierender Transistor ausgebildet sein. Das Licht emittierende Bauelement kann in verschiedenen Ausführungsbeispielen Teil einer integrierten Schaltung sein. Weiterhin kann eine Mehrzahl von Licht emittierenden Bauelementen vorgesehen sein, beispielsweise untergebracht in einem gemeinsamen Gehäuse. In verschiedenen Ausführungsbeispielen kann ein optoelektronisches Bauelement als ein Top- und/oder Bottom-Emitter eingerichtet sein. Ein Top- und/oder Bottom-Emitter kann auch als optisch transparentes Bauelement, beispielsweise eine transparente organische Leuchtdiode, bezeichnet werden.

Bei einer stoffschlüssigen Verbindung kann ein erster Körper mit einem zweiten Körper mittels atomarer und/oder molekularer Kräfte verbunden sein. Stoffschlüssige Verbindungen können häufig nicht lösbare Verbindungen sein. In verschiedenen Ausgestaltungen kann eine stoffschlüssige Verbindung beispielsweise als eine Klebeverbindung, eine Lotverbindung, beispielsweise eines Glaslotes oder eines Metalotes, oder als eine Schweißverbindung realisiert sein.

Unter dem Begriff "transluzent" bzw. "transluzente Schicht" kann in verschiedenen Ausführungsbeispielen verstanden werden, dass eine Schicht für Licht durchlässig ist, beispielsweise für das von dem lichtemittierenden Bauelement erzeugte Licht, beispielsweise einer oder mehrerer Wellenlängenbereiche, beispielsweise für Licht in einem Wellenlängenbereich des sichtbaren Lichts (beispielsweise zumindest in einem Teilbereich des Wellenlängenbereichs von 380 nm bis 780 nm). Beispielsweise ist unter dem Begriff "transluzente Schicht" in verschiedenen Ausführungsbeispielen zu verstehen, dass im Wesentlichen die gesamte in eine Struktur (beispielsweise eine Schicht) eingekoppelte Lichtmenge auch aus der Struktur (beispielsweise Schicht) ausgekoppelt wird, wobei ein Teil des Licht hierbei gestreut werden kann.

Unter dem Begriff "transparent" oder "transparente Schicht" kann in verschiedenen Ausführungsbeispielen verstanden werden, dass eine Schicht für Licht durchlässig ist (beispielsweise zumindest in einem Teilbereich des Wellenlängenbereichs von 380 nm bis 780 nm), wobei in eine Struktur (beispielsweise eine Schicht) eingekoppeltes Licht im Wesentlichen ohne Streuung oder Lichtkonversion auch aus der Struktur (beispielsweise Schicht) ausgekoppelt wird.

Ein metallisches Material kann beispielsweise ein Metall und/oder ein Halbmetall aufweisen oder sein.

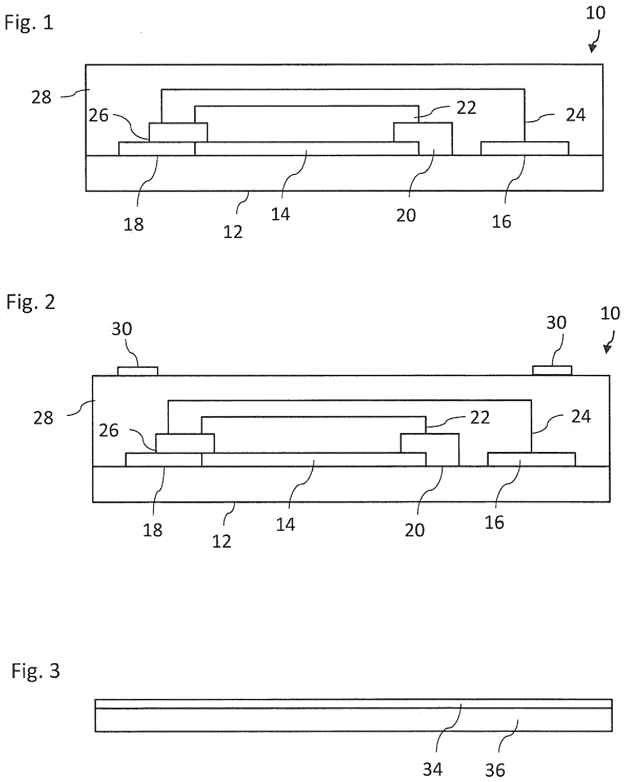

**Fig.1** zeigt erste Komponenten eines Ausführungsbeispiels eines optoelektronischen Bauelements 10 in einem ersten Zustand während eines Verfahrens zum Herstellen des optoelektronischen Bauelements 10. Das optoelektronische Bauelement 10 weist einen Träger 12 auf. Der Träger 12 kann beispielsweise als Schutzschicht ausgebildet sein. Der Träger 12 kann beispielsweise als ein Trägerelement für elektronische Elemente oder Schichten, beispielsweise lichtemittierende Elemente, dienen. Beispielsweise kann der Träger 12 Glas, Quarz und/oder ein Halbleitermaterial aufweisen oder daraus gebildet sein. Ferner kann der Träger 12 eine Kunststofffolie oder ein Laminat mit einer oder mit mehreren Kunststofffolien aufweisen oder daraus gebildet sein. Der Kunststoff kann ein oder mehrere Polyolefine (beispielsweise Polyethylen (PE) mit hoher oder niedriger Dichte oder Polypropylen (PP)) aufweisen oder daraus gebildet sein. Ferner kann der Kunststoff Polyvinylchlorid (PVC), Polystyrol (PS), Polyester und/oder Polycarbonat (PC), Polyethylenterephthalat (PET), Polyethersulfon (PES) und/oder Polyethylennaphthalat (PEN) aufweisen oder daraus gebildet sein. Der Träger 12 kann eines oder mehrere der oben genannten Materialien aufweisen. Der Träger 12 kann ein Metall oder eine Metallverbindung aufweisen oder daraus gebildet sein, beispielsweise Kupfer, Silber, Gold, Platin oder ähnliches. Der Träger 12, das ein Metall oder eine Metallverbindung aufweist, kann auch als eine Metallfolie oder eine metallbeschichtete Folie ausgebildet sein. Der Träger 12 kann transluzent oder transparent ausgeführt sein.

Auf oder über dem Träger 12 kann in verschiedenen Ausführungsbeispielen optional eine nicht dargestellte Barriereschicht angeordnet sein. Die Barriereschicht kann eines oder mehrere der folgenden Stoffe aufweisen oder daraus bestehen: Aluminiumoxid, Zinkoxid, Zirkoniumoxid, Titanoxid, Hafniumoxid, Tantaloxid, Lanthaniumoxid, Siliziumoxid, Siliziumnitrid, Siliziumoxinitrid, Indiumzinnoxid, Indiumzinkoxid, Aluminium-dotiertes Zinkoxid, sowie Mischungen und Legierungen derselben. Ferner kann die Barriereschicht in verschiedenen Ausführungsbeispielen eine Schichtdicke aufweisen in einem Bereich von ungefähr 0,1 nm (eine Atomlage) bis ungefähr 5000 nm, beispielsweise eine Schichtdicke in einem Bereich von ungefähr 10 nm bis ungefähr 200 nm, beispielsweise eine Schichtdicke von ungefähr 40 nm.

Auf oder über dem Träger 12 bzw. der Barriereschicht ist ein aktiver Bereich des optoelektronischen Bauelements 10 angeordnet. Der aktive Bereich kann als der Bereich des optoelektronischen Bauelements 10 verstanden werden, in dem elektrischer Strom zum Betrieb des optoelektronischen Bauelements 10 fließt und die elektromagnetische Strahlung erzeugt bzw. absorbiert wird. Der aktive Bereich weist eine erste Elektrodenschicht 14, eine zweite Elektrodenschicht 24 und dazwischen eine funktionelle Schichtenstruktur 22 auf. Die erste Elektrodenschicht 14 ist auf dem Träger 12 ausgebildet, sofern die Barriereschicht nicht vorhanden ist. Die erste Elektrodenschicht 14 kann aus einem elektrisch leitfähigen Material gebildet werden oder sein, wie beispielsweise aus einem Metall oder einem leitfähigen transparenten Oxid (transparent conductive oxide, TCO) oder einem Schichtenstapel mehrerer Schichten desselben Metalls oder unterschiedlicher Metalle und/oder desselben TCO oder unterschiedlicher TCOs. Transparente leitfähige Oxide sind transparente, leitfähige Stoffe, beispielsweise Metalloxide, wie beispielsweise Zinkoxid, Zinnoxid, Cadmiumoxid, Titanoxid, Indiumoxid, oder Indium-Zinn-Oxid (ITO). Neben binären Metallsauerstoffverbindungen, wie beispielsweise ZnO, SnO₂, oder In₂O₃ gehören auch ternäre Metallsauerstoffverbindungen, wie beispielsweise AlZnO, Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitfähiger Oxide zu der Gruppe der TCOs und können in verschiedenen Ausführungsbeispielen eingesetzt werden. Weiterhin entsprechen die TCOs nicht zwingend einer stöchiometrischen Zusammensetzung und können ferner p-dotiert oder n-dotiert sein. Die erste Elektrodenschicht 14 kann ein Metall aufweisen; beispielsweise Ag, Pt, Au, Mg, Al, Ba, In, Ag, Au, Mg, Ca, Sm oder Li, sowie Verbindungen, Kombinationen oder Legierungen dieser Stoffe. Die erste Elektrodenschicht 14 kann gebildet werden von einem Schichtenstapel einer Kombination einer Schicht eines Metalls auf einer Schicht eines TCOs, oder umgekehrt. Ein Beispiel ist eine Silberschicht, die auf einer Indium-Zinn-Oxid-Schicht (ITO) aufgebracht ist (Ag auf ITO) oder ITO-Ag-ITO Multischichten.

Die erste Elektrodenschicht 14 kann eines oder mehrere der folgenden Materialien alternativ oder zusätzlich zu den oben genannten Materialien aufweisen: Netzwerke aus metallischen Nanodrähten und -teilchen, beispielsweise aus Ag; Netzwerke aus Kohlenstoff-Nanoröhren; Graphen-Teilchen und -Schichten; Netzwerke aus halbleitenden Nanodrähten. Ferner kann die erste Elektrodenschicht 14 elektrisch leitfähige Polymere oder Übergangsmetalloxide oder elektrisch leitfähige transparente Oxide aufweisen.

In verschiedenen Ausführungsbeispielen können die erste Elektrodenschicht 14 und der Träger 12 transluzent oder transparent ausgebildet sein. Die erste Elektrodenschicht 14 kann beispielsweise eine Schichtdicke aufweisen in einem Bereich von ungefähr 1 nm bis ungefähr 500 nm, beispielsweise eine Schichtdicke in einem Bereich von ungefähr 10 nm bis ungefähr 250 nm, beispielsweise eine Schichtdicke in einem Bereich von ungefähr 100 nm bis ungefähr 150 nm.

Die erste Elektrodenschicht 14 kann als Anode, also als löcherinjizierende Elektrode, oder als Kathode, also als eine elektroneninjizierende Elektrode, ausgebildet sein.

Neben der ersten Elektrodenschicht 14 ist auf dem Träger 12 eine erste Kontaktzuführung 18 ausgebildet, die elektrisch mit der ersten Elektrodenschicht 14 gekoppelt ist. Die erste Kontaktzuführung 18 kann mit einem ersten elektrischen Potential (bereitgestellt von einer nicht dargestellten Energiequelle, beispielsweise einer Stromquelle oder einer Spannungsquelle) gekoppelt sein. Alternativ kann das erste elektrische Potential an den Träger 12 angelegt werden und darüber dann mittelbar an die erste Elektrodenschicht 14 angelegt werden. Das erste elektrische Potential kann beispielsweise das Massepotential oder ein anderes vorgegebenes Bezugspotential sein.

Über der ersten Elektrodenschicht 14 ist die funktionelle Schichtenstruktur 22, beispielsweise eine organische funktionelle Schichtenstruktur, ausgebildet. Die funktionelle Schichtenstruktur 22 kann eine oder mehrere Emitterschichten aufweisen, beispielsweise mit fluoreszierenden und/oder phosphoreszierenden Emittern, sowie eine oder mehrere Lochleitungsschichten (auch bezeichnet als Lochtransportschicht(en)). In verschiedenen Ausführungsbeispielen können alternativ oder zusätzlich eine oder mehrere Elektronenleitungsschichten (auch bezeichnet als Elektronentransportschicht(en)) vorgesehen sein.

Beispiele für Emittermaterialien, die in dem optoelektronischen Bauelement 10 gemäß verschiedenen Ausführungsbeispielen für die Emitterschicht(en) eingesetzt werden können, schließen organische oder organometallische Verbindungen, wie Derivate von Polyfluoren, Polythiophen und Polyphenylen (z.B. 2- oder 2,5-substituiertes Poly-p-phenylenvinylen) sowie Metallkomplexe, beispielsweise Iridium-Komplexe wie blau phosphoreszierendes FIrPic (Bis(3,5-difluoro-2-(2-pyridyl)phenyl-(2-carboxypyridyl)-iridium III), grün phosphoreszierendes Ir(ppy)3 (Tris(2-phenylpyridin)iridium III), rot phosphoreszierendes Ru (dtb-bpy)3^{∗}2(PF6) (Tris[4,4'-di-tert-butyl-(2,2')-bipyridin]ruthenium(III)komplex) sowie blau fluoreszierendes DPAVBi (4,4-Bis[4-(di-p-tolylamino)styryl]biphenyl), grün fluoreszierendes TTPA (9,10-Bis[N,N-di-(p-tolyl)-amino]anthracen) und rot fluoreszierendes DCM2 (4-Dicyanomethylen)-2-methyl-6-julolidyl-9-enyl-4H-pyran) als nichtpolymere Emitter ein. Solche nichtpolymeren Emitter sind beispielsweise mittels thermischen Verdampfens abscheidbar oder mittels Rakelns aufbringbar. Ferner können Polymeremitter eingesetzt werden, welche insbesondere mittels eines nasschemischen Verfahrens, wie beispielsweise einem Aufschleuderverfahren (auch bezeichnet als Spin Coating), abscheidbar sind. Die Emittermaterialien können in geeigneter Weise in einem Matrixmaterial eingebettet sein.

Die Emittermaterialien der Emitterschicht(en) können beispielsweise so ausgewählt sein, dass das optoelektronische Bauelement 10 Weißlicht emittiert. Die Emitterschicht(en) kann/können mehrere verschiedenfarbig (zum Beispiel blau und gelb oder blau, grün und rot) emittierende Emittermaterialien aufweisen, alternativ kann/können die Emitterschicht(en) auch aus mehreren Teilschichten aufgebaut sein, wie einer blau fluoreszierenden Emitterschicht oder blau phosphoreszierenden Emitterschicht, einer grün phosphoreszierenden Emitterschicht und einer rot phosphoreszierenden Emitterschicht. Durch die Mischung der verschiedenen Farben kann die Emission von Licht mit einem weißen Farbeindruck resultieren. Alternativ kann auch vorgesehen sein, im Strahlengang der durch diese Schichten erzeugten Primäremission ein Konvertermaterial anzuordnen, das die Primärstrahlung zumindest teilweise absorbiert und eine Sekundärstrahlung anderer Wellenlänge emittiert, so dass sich aus einer (noch nicht weißen) Primärstrahlung durch die Kombination von primärer Strahlung und sekundärer Strahlung ein weißer Farbeindruck ergibt.

Die funktionelle Schichtenstruktur 22 kann allgemein eine oder mehrere elektrolumineszente Schichten aufweisen. Die elektrolumineszenten Schichten können organische Polymere, organische Oligomere, organische Monomere, organische kleine, nicht-polymere Moleküle ("small molecules") oder eine Kombination dieser Stoffe aufweisen. Beispielsweise kann die funktionelle Schichtenstruktur 22 eine oder mehrere elektrolumineszente Schichten aufweisen, die als Lochtransportschicht ausgeführt sind, so dass beispielsweise in dem Fall einer OLED eine effektive Löcherinjektion in eine elektrolumineszierende Schicht oder einen elektrolumineszierenden Bereich ermöglicht wird. Alternativ kann in verschiedenen Ausführungsbeispielen die funktionelle Schichtenstruktur 22 eine oder mehrere funktionelle Schichten aufweisen, die als Elektronentransportschicht ausgeführt ist, so dass beispielsweise in einer OLED eine effektive Elektroneninjektion in eine elektrolumineszierende Schicht oder einen elektrolumineszierenden Bereich ermöglicht wird. Als Material für die Lochtransportschicht können beispielsweise tertiäre Amine, Carbazoderivate, leitendes Polyanilin oder Polythylendioxythiophen verwendet werden. In verschiedenen Ausführungsbeispielen können die elektrolumineszenten Schichten als elektrolumineszierende Schicht ausgeführt sein.

In verschiedenen Ausführungsbeispielen kann die Lochtransportschicht auf oder über der ersten Elektrodenschicht 14 aufgebracht, beispielsweise abgeschieden, sein, und die Emitterschicht kann auf oder über der Lochtransportschicht aufgebracht sein, beispielsweise abgeschieden sein. In verschiedenen Ausführungsbeispielen kann die Elektronentransportschicht auf oder über der Emitterschicht aufgebracht, beispielsweise abgeschieden, sein.

In verschiedenen Ausführungsbeispielen kann die funktionelle Schichtenstruktur 22 eine Schichtdicke aufweisen in einem Bereich von ungefähr 10 nm bis ungefähr 3 µm, beispielsweise von ungefähr 100 nm bis ungefähr 1 µm, beispielsweise von ungefähr 300 nm bis ungefähr 800 nm. In verschiedenen Ausführungsbeispielen kann die funktionelle Schichtenstruktur 22 beispielsweise einen Stapel von übereinander angeordneten der genannten Schichten aufweisen.

Das optoelektronische Bauelement 10 kann optional allgemein weitere Funktionsschichten, beispielsweise angeordnet auf oder über der einen oder mehreren Emitterschichten oder auf oder über der oder den Elektronentransportschicht(en) aufweisen, die dazu dienen, die Funktionalität und damit die Effizienz des optoelektronischen Bauelements 10 weiter zu verbessern.

Über der funktionellen Schichtenstruktur 22 ist die zweite Elektrodenschicht 24 ausgebildet. Neben der ersten Elektrodenschicht 14, und zwar auf einer von der ersten Kontaktzuführung 18 abgewandten Seite der ersten Elektrodenschicht 14, ist über dem Träger 12 eine zweite Kontaktzuführung 16 ausgebildet. Die zweite Kontaktzuführung 16 ist mit der zweiten Elektrodenschicht 24 elektrisch gekoppelt. Die zweite Kontaktzuführung 16 dient zum elektrischen Kontaktieren der zweiten Elektrodenschicht 24. An die zweite Kontaktzuführung 16 ist ein zweites elektrisches Potential anlegbar. Das zweite elektrische Potential kann beispielsweise einen Wert aufweisen derart, dass die Differenz zu dem ersten elektrischen Potential einen Wert in einem Bereich von ungefähr 1,5 V bis ungefähr 20 V aufweist, beispielsweise einen Wert in einem Bereich von ungefähr 2,5 V bis ungefähr 15 V, beispielsweise einen Wert in einem Bereich von ungefähr 3 V bis ungefähr 12 V. Die zweite Elektrodenschicht 24 kann die gleichen Stoffe aufweisen oder daraus gebildet sein wie die erste Elektrodenschicht 14. Die zweite Elektrodenschicht 24 kann beispielsweise eine Schichtdicke aufweisen in einem Bereich von ungefähr 1 nm bis ungefähr 100 nm, beispielsweise von ungefähr 10 nm bis ungefähr 50 nm, beispielsweise von ungefähr 15 nm bis ungefähr 30 nm. Die zweite Elektrodenschicht 24 kann allgemein in ähnlicher Weise ausgebildet werden wie die erste Elektrodenschicht 14 oder unterschiedlich zu dieser. Die zweite Elektrodenschicht 24 kann als Anode, also als löcherinjizierende Elektrode, oder als Kathode, also als eine elektroneninjizierende Elektrode, ausgebildet sein.

In verschiedenen Ausführungsbeispielen sind die erste Elektrodenschicht 14 und die zweite Elektrodenschicht 24 beide transluzent oder transparent ausgebildet. Somit kann das optoelektronische Bauelement 10 als Top- und Bottom-Emitter und/oder als transparentes optoelektronisches Bauelement 10 ausgebildet sein.

Die elektrischen Kontaktzuführungen 18, 16 können beispielsweise als Teile der Anode bzw. Kathode dienen. Die elektrischen Kontaktzuführungen 18, 16 können transparent oder nicht transparent ausgebildet sein. Die elektrischen Kontaktzuführungen 18, 16 können beispielsweise Teilschichten aufweisen, die beispielsweise Molybdän/Aluminium/Molybdän, Chrom/Aluminium/Chrom, Silber/Magnesium oder ausschließlich Aluminium aufweisen. Die zweite Elektrodenschicht 24 ist von der ersten Kontaktzuführung 18 und der ersten Elektrodenschicht 14 durch eine erste Isolatorschicht 20 und eine zweite Isolatorschicht 26 abgegrenzt. Die Isolatorschichten 20, 26 weisen beispielsweise Polyimid auf und sind optional ausgebildet.

Der Träger 12 mit der ersten Elektrodenschicht 14, den Kontaktzuführungen 16, 18, und den Isolatorschichten 20, 26 kann auch als Substrat bezeichnet werden. Auf dem Substrat wird die funktionelle Schichtenstruktur 22 ausgebildet.

Über der zweiten Elektrodenschicht 24 und teilweise über der ersten Kontaktzuführung 18, der zweiten Kontaktzuführung 16 und der zweiten Isolatorschicht 26 ist eine Verkapselungsschicht 28 ausgebildet. Die Verkapselungsschicht 28 bedeckt somit die erste Kontaktzuführung 18 und die zweite Kontaktzuführung 16, wobei diese zum elektrischen Kontaktieren der Kontaktzuführungen 18, 16 nachfolgend zumindest teilweise freigelegt werden können. Die Verkapselungsschicht 28 kann beispielsweise in Form einer Barrierendünnschicht oder Dünnschichtverkapselung ausgebildet werden. Unter einer "Barrierendünnschicht" bzw. einer "Dünnschichtverkapselung" kann eine Schicht oder eine Schichtenstruktur verstanden werden, die dazu geeignet ist, eine Barriere gegenüber chemischen Verunreinigungen bzw. atmosphärischen Stoffen, insbesondere gegenüber Wasser (Feuchtigkeit) und Sauerstoff, zu bilden. Mit anderen Worten ist die Verkapselungsschicht 28 derart ausgebildet, dass sie beispielsweise von OLED-schädigenden Stoffen wie Wasser, Sauerstoff oder Lösemittel nicht oder höchstens zu sehr geringen Anteilen durchdrungen werden kann.

Gemäß einer Ausgestaltung kann die Verkapselungsschicht 28 als eine einzelne Schicht (anders ausgedrückt, als Einzelschicht) ausgebildet sein. Gemäß einer alternativen Ausgestaltung kann die Verkapselungsschicht 28 eine Mehrzahl von aufeinander ausgebildeten Teilschichten aufweisen. Mit anderen Worten kann gemäß einer Ausgestaltung die Verkapselungsschicht 28 als Schichtstapel (Stack) ausgebildet sein. Die Verkapselungsschicht 28 oder eine oder mehrere Teilschichten der Verkapselungsschicht 28 können beispielsweise mittels eines geeigneten Abscheideverfahrens gebildet werden, z.B. mittels eines Atomlagenabscheideverfahrens (Atomic Layer Deposition (ALD)), z.B. eines plasmaunterstützten Atomlagenabscheideverfahrens (Plasma Enhanced Atomic Layer Deposition (PEALD)) oder eines plasmalosen Atomlagenabscheideverfahrens (Plasma-less Atomic Layer Deposition (PLALD)), oder mittels eines chemischen Gasphasenabscheideverfahrens (Chemical Vapor Deposition (CVD)), z.B. eines plasmaunterstützten Gasphasenabscheideverfahrens (Plasma Enhanced Chemical Vapor Deposition (PECVD)) oder eines plasmalosen Gasphasenabscheideverfahrens (Plasma-less Chemical Vapor Deposition (PLCVD)). Gemäß einer Ausgestaltung können bei der Verkapselungsschicht 28, die mehrere Teilschichten aufweist, alle Teilschichten mittels eines Atomlagenabscheideverfahrens gebildet werden. Eine Schichtenfolge, die nur ALD-Schichten aufweist, kann auch als "Nanolaminat" bezeichnet werden. Durch Verwendung eines Atomlagenabscheideverfahrens (ALD) können sehr dünne Schichten abgeschieden werden. Insbesondere können Schichten abgeschieden werden, deren Schichtdicken im Atomlagenbereich liegen.

Die Verkapselungsschicht 28 kann gemäß einer Ausgestaltung eine Schichtdicke von ungefähr 0.1 nm (eine Atomlage) bis ungefähr 1000 nm aufweisen, beispielsweise eine Schichtdicke von ungefähr 10 nm bis ungefähr 100 nm, beispielsweise ungefähr 40 nm.

Gemäß einer Ausgestaltung, bei der die Verkapselungsschicht 28 mehrere Teilschichten aufweist, können alle Teilschichten die gleiche Schichtdicke aufweisen. Gemäß einer anderen Ausgestaltung können die einzelnen Teilschichten der Verkapselungsschicht 28 unterschiedliche Schichtdicken aufweisen. Mit anderen Worten kann mindestens eine der Teilschichten eine andere Schichtdicke aufweisen als eine oder mehrere andere der Teilschichten. Die Verkapselungsschicht 28 oder die einzelnen Teilschichten der Verkapselungsschicht 28 können als transluzente oder transparente Schicht ausgebildet sein.

Gemäß einer Ausgestaltung kann die Verkapselungsschicht 28 oder eine oder mehrere der Teilschichten der Verkapselungsschicht 28 eines der nachfolgenden Materialien aufweisen oder daraus gebildet sein: Aluminiumoxid, Zinkoxid, Zirkoniumoxid, Titanoxid, Hafniumoxid, Tantaloxid Lanthaniumoxid, Siliziumoxid, Siliziumnitrid, Siliziumoxinitrid, Indiumzinnoxid, Indiumzinkoxid, Aluminium-dotiertes Zinkoxid, sowie Mischungen und Legierungen derselben. In verschiedenen Ausführungsbeispielen können die Verkapselungsschicht 28 oder eine oder mehrere der Teilschichten der Verkapselungsschicht 28 ein oder mehrere hochbrechende Materialien aufweisen, anders ausgedrückt ein oder mehrere Materialien mit einem hohen Brechungsindex, beispielsweise mit einem Brechungsindex von mindestens 2.

Die Verkapselungsschicht 28 kann die darunter liegenden Schichten beispielsweise flächig ohne laterale Strukturierung bedecken. In dieser Anmeldung bezeichnet die laterale Richtung eine Richtung, die parallel zu der Ebene ist, die durch die Oberfläche des Trägers 12 gebildet ist, auf der die erste Elektrodenschicht 14 ausgebildet ist.

In verschiedenen Ausführungsbeispielen kann über der zweiten Elektrodenschicht 24 eine elektrisch isolierende Schicht (nicht dargestellt) aufgebracht werden, beispielsweise SiN, SiOₓ, SiNOₓ oder ATO, beispielsweise AlTiOₓ, beispielsweise mit einer Schichtdicke in einem Bereich von ungefähr 300 nm bis ungefähr 1,5 µm, beispielsweise mit einer Schichtdicke in einem Bereich von ungefähr 500 nm bis ungefähr 1 µm, um elektrisch instabile Stoffe zu schützen. Ferner können in verschiedenen Ausführungsbeispielen zusätzlich eine oder mehrere Entspiegelungsschichten vorgesehen sein.

**Fig. 2** zeigt das optoelektronische Bauelement 10 gemäß Figur 1 in einem zweiten Zustand während des Verfahrens zum Herstellen des optoelektronischen Bauelements 10. In diesem Zustand ist eine Rahmenstruktur 30 auf der Verkapselungsschicht 28 ausgebildet. Die Rahmenstruktur 30 ist lateral strukturiert auf der Verkapselungsschicht 28 ausgebildet, wobei in Figur 2 lediglich zwei Seitenelemente der Rahmenstruktur 30 gezeigt sind. In Draufsicht kann die Rahmenstruktur 30 jedoch rahmenförmig ausgebildet sein, wobei sie in Draufsicht einen Rahmen um die funktionelle Schichtenstruktur 22 bilden kann. Alternativ dazu kann die Rahmenstruktur 30 beispielsweise flächig geschlossen auf der Verkapselungsschicht 28 ausgebildet sein oder auf diese aufgebracht werden.

Die Rahmenstruktur 30 weist ein erstes metallisches Material auf. Das erste metallische Material kann beispielsweise Aluminium, Zink, Chrom, Kupfer, Molybdän, Silber, Gold, Nickel, Gallium, Indium und/oder Zinn aufweisen. Die Rahmenstruktur 30 kann beispielsweise eine Dicke im Bereich von 10 nm bis 100 µm beispielsweise von 15 nm bis 50 µm beispielsweise von 20 nm bis 25 µm aufweisen. Die Rahmenstruktur 30 kann beispielsweise mehrere Teilschichten aufweisen, die übereinander ausgebildet sind. Die Rahmenstruktur 30 kann beispielsweise zunächst flächig geschlossen auf die Verkapselungsschicht 28 aufgebracht werden und nachfolgend strukturiert werden, beispielsweise mit Hilfe eines Maskierungs- und Abtragungsprozesses, oder die Rahmenstruktur 30 kann direkt strukturiert aufgebracht werden, beispielsweise mit Hilfe eines Druckverfahrens. Die Rahmenstruktur 30 kann beispielsweise fest oder flüssig, beispielsweise zähflüssig, vorliegen. Beispielsweise kann die Rahmenstruktur 30 von einer flüssigen Haftlegierung oder Ausgangslegierung gebildet sein.

**Fig. 3** zeigt weitere Komponenten des optoelektronischen Bauelements 10 in einem ersten Zustand während des Verfahrens zum Herstellen des optoelektronischen Bauelements 10. Insbesondere zeigt Figur 3 einen Abdeckkörper 36, auf dem eine Haftschicht 34 ausgebildet ist. Der Abdeckkörper 36 kann beispielsweise Glas aufweisen und/oder von einem Laminierglas gebildet sein. Die Haftschicht 34 weist ein zweites metallisches Material auf. Das zweite metallische Material kann das gleiche metallische Material sein wie das erste metallische Material. Alternativ dazu kann das zweite metallische Material jedoch auch ein anderes metallisches Material sein. Alternativ dazu kann der Abdeckkörper 36 auch als Schutzschicht oder Folie ausgebildet sein. Die Haftschicht 34 kann flächig geschlossen auf dem Abdeckkörper 36 oder in lateraler Richtung strukturiert auf dem Abdeckkörper 36 ausgebildet sein. Falls die Haftschicht 34 strukturiert ausgebildet ist, so kann sie beispielsweise zunächst flächig geschlossen auf den Abdeckkörper 36 aufgebracht werden und nachfolgend strukturiert werden, beispielsweise mit Hilfe eines Maskierungs- und/oder Abtragungsprozesses, oder die Haftschicht 34 kann direkt strukturiert aufgebracht werden, beispielsweise mit Hilfe eines Druckverfahrens. Die strukturierte Haftschicht 34 kann von einer Antihaftschicht begrenzt sein. Alternativ dazu kann die Haftschicht 34 von dem Abdeckköper 36 gebildet sein. In anderen Worten können optional der Abdeckkörper 36 und die Haftschicht 34 einstückig ausgebildet sein.

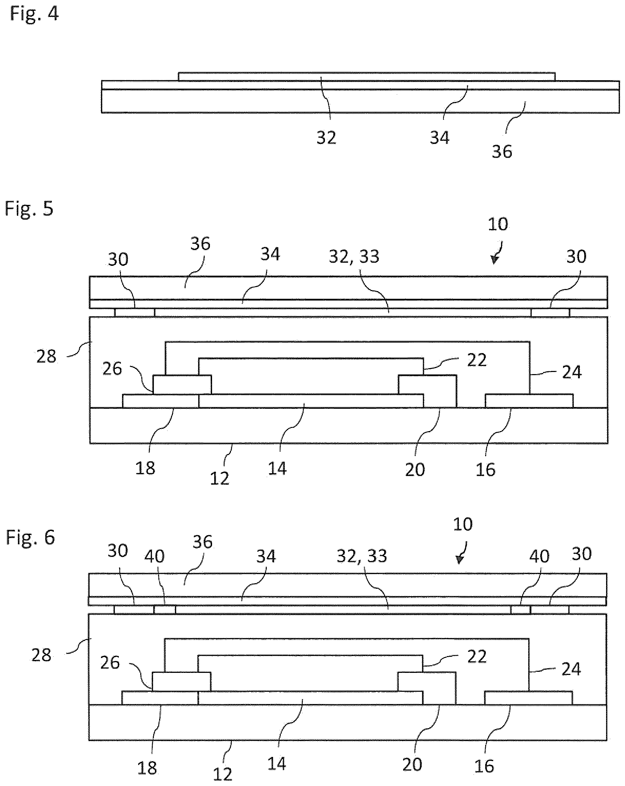

**Fig. 4** zeigt die weiteren Komponenten des optoelektronischen Bauelements 10 aus Figur 3 in einem zweiten Zustand während des Verfahrens zum Herstellen des optoelektronischen Bauelements 10. Insbesondere zeigt Figur 4 den Abdeckkörper 36 mit der Haftschicht 34. Auf der Haftschicht 34 ist eine flüssige erste Legierung 32, also in flüssigem Aggregatszustand, aufgebracht. Die erste Legierung 32 ist lediglich in einem Teilbereich auf die Haftschicht 34 aufgebracht. Der Teilbereich kann beispielsweise zu dem Rahmen, der von der in Figur 6 gezeigten Rahmenstruktur 30 gebildet ist, oder einem von dem Rahmen umspannten Bereich korrespondieren. Das Aufbringen der flüssigen ersten Legierung 32 lediglich in dem Teilbereich kann beispielsweise über die Menge der ersten Legierung 32 gesteuert werden und/oder mit Hilfe der nicht dargestellten Antihaftschichten, die beispielsweise die zweite Haftschicht 34 korrespondierend zu der Rahmenstruktur 30 rahmenförmigen begrenzen. Eine derartige Antihaftschicht kann beispielsweise Titanoxid, Galliumoxid, Wolframoxid, Zirkoniumoxid und/oder Aluminiumoxid aufweisen.

Die erste Legierung 32 hat einen niedrigen Schmelzpunkt. Die erste Legierung 32 befindet sich bei Temperaturen in einem Bereich zwischen -20° C und 100° C, beispielsweise zwischen 0° C und 80° C, beispielsweise zwischen 20° C und 30° C in ihrem flüssigen Aggregatszustand. Beispielsweise ist die erste Legierung 32 bei Raumtemperatur flüssig. In anderen Worten kann die erste Legierung 32 in flüssigen Zustand bei Raumtemperatur auf die Haftschicht 34 aufgebracht werden. Die erste Legierung 32 kann beispielsweise mittels Druckens, Dispensens und/oder als Lösung aufgebracht werden.

Die Moleküle der ersten Legierung 32 gehen dort, wo sie in Kontakt mit den Molekülen und/oder Atomen der Haftschicht 34 sind, Verbindungen, beispielsweise chemische Verbindungen, mit den entsprechenden Atomen bzw. Molekülen ein. Dadurch bildet sich eine zweite Legierung 33, deren Schmelzpunkt deutlich höher ist als der der ersten Legierung 23. Insbesondere sind die Materialien der ersten Legierung 32 und der Haftschicht 34 und die Prozessparameter, wie beispielsweise die Verarbeitungstemperatur und der Luftdruck beim Verarbeiten so gewählt, dass der Schmelzpunkt der ersten Legierung 32 unter der Prozesstemperatur und der Schmelzpunkt der zweiten Legierung 33 über der Prozesstemperatur liegt. Dies bewirkt, dass die zweite Legierung 33 bei ihrer Bildung oder kurz danach erstarrt und sich fest mit der Haftschicht 34 verbindet. Die zweite Legierung 32 wird derart dick auf die Haftschicht 34 aufgebracht, dass lediglich ein Teil der ersten Legierung 32 mit dem Material der Haftschicht 34 reagiert und ein anderer Teil der ersten Legierung zumindest zunächst flüssig bleibt.

Die erste Legierung 32 kann beispielsweise Gallium, Indium, Zinn, Kupfer, Molybdän, Silber und/oder Bismut aufweisen. Die erste Legierung 32 kann beispielsweise GaInSn aufweisen, beispielsweise zwischen 60% und 70% Gallium, zwischen 20% und 30% Indium und zwischen 10% und 20% Zinn. Die erste Legierung 32 kann beispielsweise 68% Gallium, 22% Indium und 10% Zinn aufweisen, wobei die erste Legierung 32 dann ihren Schmelzpunkt bei ungefähr -19,5° C hat und wobei die erste Legierung dann Glas, beispielsweise den Abdeckkörper 36, benetzt. Alternativ dazu kann die erste Legierung 32 beispielsweise 62% Gallium, 22% Indium und 16% Zinn aufweisen, wobei die erste Legierung 32 dann ihren Schmelzpunkt bei ungefähr 10,7° C hat und wobei die erste Legierung 32 dann als Fieldsches Metall bezeichnet werden kann. Der genaue Schmelzpunkt kann abhängig von dem Zinnanteil in der ersten Legierung eingestellt werden. Alternativ dazu kann die erste Legierung 32 InBiSn aufweisen, beispielsweise 51% Indium, 33% Bismut und 16% Zinn, wobei die erste Legierung dann ihren Schmelzpunkt bei ungefähr 62° C hat und wobei die erste Legierung dann Glas, beispielsweise den Abdeckkörper 36 benetzt, und wobei die erste Legierung 32 dann auf einer heißen Platte (hot plate) bearbeitbar ist. Dementsprechend kann die zweite Legierung 33 beispielsweise GaInSn mit einer deutlich höheren Zinnkonzentration oder GaInSnAl aufweisen. Die erste Legierung 32 kann mit einer Dicke von beispielsweise 10 nm bis 50 µm, beispielsweise von 20 nm bis 25 µm ausgebildet werden.

**Fig. 5** zeigt die Komponenten des optoelektronischen Bauelements 10 gemäß den Figuren 1 bis 4, wobei der Abdeckkörper 36 mit der Haftschicht 34 und der ersten Legierung 32 und der zweiten Legierung 33 auf die Rahmenstruktur 30 aufgebracht ist. Alternativ oder zusätzlich zu dem Aufbringen der ersten Legierung 32 auf die Haftschicht 34 kann die erste Legierung auch auf die Rahmenstruktur 30 aufgebracht werden. In diesem Zusammenhang kann optional die Antihaftschicht neben der Rahmenstruktur 30 ausgebildet sein, beispielsweise um präzise vorzugeben, wo die erste Legierung 32 angeordnet sein soll und wo nicht.

Die erste Legierung 32 bildet in einer chemischen Reaktion mit den metallischen Materialien der Rahmenstruktur 30 und der zweiten Haftschicht 34 die zweite Legierung 33, die erstarrt und so den Abdeckkörper 36 fest mit der Verkapselungsschicht 28 koppelt. Darüber hinaus dichtet die zweite Legierung 33 den Bereich über der funktionellen Schichtenstruktur 22 in lateraler Richtung ab. Die erste Legierung 32 und die Haftschichten 30, 34 können derart ausgebildet sein, dass die erste Legierung 32 vollständig zu der zweiten Legierung 33 reagiert. Die erste Legierung 32 bzw. die Haftschichten 30, 34 können alternativ jedoch auch so ausgebildet sein, dass die erste Legierung 32 nur teilweise zu der zweiten Legierung 33 reagiert und das in einem oder mehreren Teilbereichen auch nach Fertigstellung des optoelektronischen Bauelements 10 die erste Legierung 32 in flüssigem Zustand vorliegt. Beispielsweise kann bei fertiggestelltem optoelektronische Bauelement 10 die erste Legierung 32 oberhalb der funktionellen Schichtenstruktur 22 in flüssigem Zustand vorliegen. Dies kann dazu beitragen, interne Spannungen, beispielsweise aufgrund thermischer und/oder mechanischer Belastung, zu verringern und Beschädigung des optoelektronischen Bauelements 10 zu verhindern. Ferner kann dies dazu beitragen, Beschädigungen des optoelektronischen Bauelements 10 zu vermindern oder zu verhindern, falls bei dem Verfahren Partikel in den Schichtaufbau eindringen. Die flüssige erste Legierung 32 kann dann beispielsweise als Puffer dienen. Ferner kann die flüssige erste Legierung 32 bei Rissen und/oder Löchern in der Verkapselungsschicht 28 in die entsprechenden Risse bzw. Löcher eindringen und diese verschließen.

**Fig. 6** zeigt ein optoelektronisches Bauelement 10, das beispielsweise weitgehend dem in Figur 5 gezeigten optoelektronischen Bauelement 10 entsprechen kann. Das optoelektronische Bauelement 10 weist angrenzend an die Rahmenstruktur 30 zumindest abschnittsweise ein nicht reaktives Material 40 auf. Das nicht reaktive Material 40 reagiert insbesondere nicht chemisch mit der ersten Legierung 32. In anderen Worten bildet sich in Kontaktbereichen, in denen die erste Legierung 32 das nicht reaktive Material 40 berührt, keine zweite Legierung 33. Das nicht reaktive Material 40 kann beispielsweise so neben der Rahmenstruktur 30 angeordnet sein, dass zwischen den Abschnitten des nicht reaktiven Materials 40 nach wie vor die erste Legierung 32 mit dem metallischen Material der Rahmenstruktur 30 reagieren kann, dass jedoch die Gesamtreaktion beschränkt ist, wodurch verhindert werden kann, dass die gesamte erste Legierung 32 zu der zweiten Legierung 33 reagiert. Dadurch können gezielt Bereiche geschaffen werden, in denen auch nach Fertigstellung des optoelektronischen Bauelements 10 die erste Legierung 32 in flüssigem Zustand vorliegt.

Das nicht reaktive Material kann beispielsweise Nickel, Aluminiumoxid, Titaniumoxid, Zirkoniumoxid und/oder Zinkoxid aufweisen. Das nicht reaktive Material kann beispielsweise mittels Dispensens, Druckens aus Emulsion und/oder Lösung und/oder mittels Sputtern aufgebracht werden. Das nicht reaktive Material 40 kann so gewählt werden, dass es lediglich nicht mit der ersten Legierung 32 reagiert oder dass die erste Legierung 32 das nicht reaktive Material 40 nicht einmal benetzt. Alternativ oder zusätzlich zu dem nicht reaktiven Material 40 können Bereiche vorgesehen sein, die frei von jeglichem Material sind und lediglich Luft oder Vakuum aufweisen. Derartige Bereiche können beispielsweise mit Hilfe der nicht von der ersten Legierung 32 benetzbaren Antihaftschichten geschaffen werden. Mit Hilfe dieser freien Bereiche kann eine ungewollte Weiterreaktion der ersten Legierung 32 eingeschränkt und/oder verhindert werden.

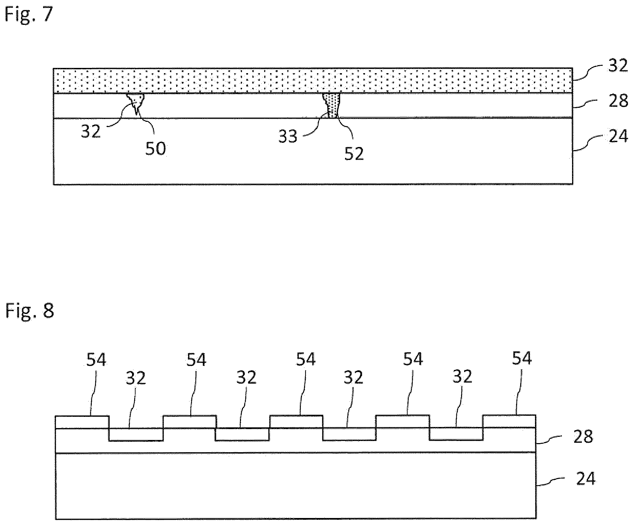

**Fig. 7** zeigt eine Detailansicht der zweiten Elektrodenschicht 24, der Verkapselungsschicht 28 und der ersten Legierung 32. In der Verkapselungsschicht 28 sind Störstellen, insbesondere ein Riss 50 und ein Loch 52, gebildet. Der Riss 50 erstreckt sich nicht bis hin zu der zweiten Elektrodenschicht 24. Das Loch 52 erstreckt sich bis hin zu der zweiten Elektrodenschicht 24. Alternativ dazu kann sich der Riss 50 bis hin zu der zweiten Elektrodenschicht 24 erstrecken und/oder das Loch 52 kann sich nicht bis hin zu der zweiten Elektrodenschicht 24 erstrecken. Der Riss 50 und/oder das Loch 52 können bei der Herstellung, bei der Lagerung und/oder beim Betrieb des optoelektronischen Bauelements 10 entstehen.

Die flüssige erste Legierung 32 fließt in den Riss 50 und das Loch 52 und verschließt so den Riss 50 bzw. das Loch 52. Die zweite Elektrodenschicht 24 kann ein metallisches Material aufweisen, das beispielsweise einem der im Vorhergehenden genannten metallischen Materialien entsprechen kann. Das metallische Material der zweiten Elektrodenschicht 24 kann so gewählt sein, dass die erste Legierung 32, die in dem Loch 52 in direkten körperlichen Kontakt mit der zweiten Elektrodenschicht 24 kommt, mit dem metallischen Material chemisch reagiert und dann eine Legierung bildet, beispielsweise die zweite Legierung 33, die dann erstarrt und das Loch 52 fest und/oder dicht verschließt. Auf diese Weise ist das optoelektronische Bauelement 10 in der Lage, auftretende Störstellen selbst zu reparieren und/oder zu heilen.

**Fig. 8** zeigt eine Detailansicht der zweiten Elektrodenschicht 24, der Verkapselungsschicht 28 und der ersten Legierung 32. Über der Verkapselungsschicht 28 ist eine Antihaftschicht 54 gebildet. Die Antihaftschicht 54 kann beispielsweise gemäß einer der im Vorhergehenden erläuterten Antihaftschichten ausgebildet sein. Die Verkapselungsschicht 28 kann mehrere Ausnehmungen aufweisen, in denen die erste Legierung 32 angeordnet ist. Die erste Legierung 32 benetzt die Antihaftschichten 54 nicht und ist von diesen begrenzt. Die Ausnehmungen können als Partikelfänger dienen. Dies ermöglicht, Standardverkapselungsverfahren, wie beispielsweise eine Cavityverkapselung, eine Frittenverkapselung, oder ein Laminat (Überkleben) anzuwenden.

Die Erfindung ist nicht auf die angegebenen Ausführungsbeispiele beschränkt. Beispielsweise kann das optoelektronische Bauelement 10 weniger oder mehr Schichten aufweisen. Beispielsweise kann das optoelektronische Bauelement 10 eine Spiegelschicht, eine Antireflexschicht und/oder eine Auskoppelschicht aufweisen. Ferner können die Ausführungsbeispiele miteinander kombiniert werden. Beispielsweise kann das in Figur 6 gezeigte optoelektronische Bauelemente 10 mit Hilfe des mit Bezug zu den Figuren 1 bis 5 gezeigten Verfahrens hergestellt werden. Ferner können innerhalb eines einzigen der optoelektronischen Bauelemente 10 immer die gleichen Legierungen und metallischen Materialien verwendet werden. Alternativ dazu können an unterschiedlichen Stellen innerhalb eines der optoelektronischen Bauelemente 10 entsprechend unterschiedliche Legierungen und/oder unterschiedliche metallische Materialien verwendet werden, wobei dabei gegebenenfalls unterschiedliche Schmelzpunkte der Legierungen vorteilhaft ausgenutzt werden können.

## Patentansprüche

1. Verfahren zum Herstellen eines optoelektronischen Bauelements (10), bei dem
- eine optoelektronische Schichtenstruktur mit einer funktionellen Schichtenstruktur (22) über einem Träger (12) ausgebildet wird,
- eine Rahmenstruktur (30), die ein erstes metallisches Material aufweist, auf der optoelektronischen Schichtenstruktur so ausgebildet wird, dass ein Bereich über der funktionellen Schichtenstruktur (22) frei von der Rahmenstruktur (30) ist und dass die Rahmenstruktur (30) den Bereich umgibt,
- eine Haftschicht (34), die ein zweites metallisches Material aufweist, über einem Abdeckkörper (36) ausgebildet wird,
- eine flüssige erste Legierung (32), deren Schmelzpunkt in einem Bereich zwischen -20° C und 100° C liegt, in dem Bereich auf die erste optoelektronische Schichtenstruktur und/oder auf die Haftschicht (34) des Abdeckkörpers (36) aufgebracht wird,
- der Abdeckkörper (36) so mit der optoelektronischen Schichtenstruktur gekoppelt wird, dass die Haftschicht (34) mit der Rahmenstruktur (30) gekoppelt ist und die flüssige erste Legierung (32) mit der Haftschicht (34) und der Rahmenstruktur (30) in direktem körperlichen Kontakt ist, und
- zumindest ein Teil der ersten Legierung (32) mit den metallischen Materialien der Rahmenstruktur (30) und der Haftschicht (34) chemisch reagiert, wodurch mindestens eine zweite Legierung (33) gebildet wird, die erstarrt und so den Abdeckkörper (36) fest mit der optoelektronischen Schichtenstruktur verbindet.

2. Verfahren nach Anspruch 1, bei dem der Schmelzpunkt der ersten Legierung (32) in einem Bereich liegt zwischen 0° C und 80° C, insbesondere zwischen 20° C und 30° C.

3. Verfahren nach Anspruch 2, bei dem die erste Legierung (32) bei Raumtemperatur flüssig ist.

4. Verfahren nach einem der vorstehenden Ansprüche, bei dem die erste Legierung (32) Gallium, Indium, Zinn, Kupfer, Molybdän, Silber und/oder Bismut aufweist.

5. Verfahren nach einem der vorstehenden Ansprüche, bei dem das erste und/oder zweite metallische Material Aluminium, Zink, Chrom, Kupfer, Molybdän, Silber, Gold, Nickel, Gallium, Indium und/oder Zinn aufweist.

6. Verfahren nach einem der vorstehenden Ansprüche, bei dem die optoelektronische Schichtenstruktur eine Verkapselungsschicht (28) aufweist und bei dem die Rahmenstruktur (30) auf der Verkapselungsschicht (28) ausgebildet wird.

7. Verfahren nach einem der vorstehenden Ansprüche, bei dem lateral benachbart zu der Rahmenstruktur (30) zumindest abschnittsweise eine erste Antihaftschicht ausgebildet wird, deren Material nicht mit der ersten Legierung (32) chemisch reagiert und/oder die von der ersten Legierung (32) nicht benetzt wird.

8. Verfahren nach einem der vorstehenden Ansprüche, bei dem lateral benachbart zu der Haftschicht (34) über dem Abdeckkörper (36) eine zweite Antihaftschicht ausgebildet wird, deren Material nicht mit der ersten Legierung (32) chemisch reagiert und/oder die von der ersten Legierung (32) nicht benetzt wird.

9. Optoelektronisches Bauelement (10), mit
- einem Träger (12),
- einer optoelektronischen Schichtenstruktur mit einer funktionellen Schichtenstruktur (22) über dem Träger (12),
- einer Rahmenstruktur (30), die ein erstes metallisches Material aufweist, über der optoelektronischen Schichtenstruktur, wobei ein Bereich über der funktionellen Schichtenstruktur (22) frei von der Rahmenstruktur (30) ist und die Rahmenstruktur (30) den Bereich umgibt,
- einem Abdeckkörper mit einer Haftschicht (34), die ein zweites metallisches Material aufweist und die mit der Rahmenstruktur (30) gekoppelt ist,
- einer flüssigen ersten Legierung (32), deren Schmelzpunkt in einem Bereich zwischen -20° C und 100° C liegt und die in dem Bereich auf der optoelektronischen Schichtenstruktur angeordnet ist, und
- einer zweiten Legierung (33), die aus einer chemischen Reaktion der ersten Legierung (32) mit den metallischen Materialien der Rahmenstruktur (30) und der Haftschicht (34) hervorgeht, wobei die zweite Legierung starr ist und den Abdeckkörper (36) fest mit der optoelektronischen Schichtenstruktur verbindet.

10. Optoelektronisches Bauelement (10) nach Anspruch 9, bei dem der Schmelzpunkt der ersten Legierung (32) in einem Bereich liegt zwischen 0° C und 80° C, insbesondere zwischen 20° C und 30° C.

11. Optoelektronisches Bauelement (10) nach Anspruch 10, bei dem die erste Legierung (32) bei Raumtemperatur flüssig ist.

12. Optoelektronisches Bauelement (10) nach einem der Ansprüche 9 bis 11, bei dem die erste Legierung (32) Gallium, Indium, Zinn und/oder Bismut aufweist.

13. Optoelektronisches Bauelement (10) nach einem der Ansprüche 9 bis 12, bei dem das erste und/oder zweite metallische Material Aluminium und/oder Zink aufweist.

14. Optoelektronisches Bauelement (10) nach einem der Ansprüche 9 bis 13, bei dem die optoelektronische Schichtenstruktur eine Verkapselungsschicht (28) aufweist und bei dem die Rahmenstruktur (30) auf der Verkapselungsschicht (28) ausgebildet ist.

## Claims

1. A method for forming an optoelectronic component, comprising the steps of:
forming an optoelectronic layer structure having a functional layer structure (22) above a carrier (12),
forming a frame structure (30) comprising a first metallic material on the optoelectronic layer structure (22) such that an area above the functional layer structure (22) is exposed by the frame structure (30) and that the frame structure (30) surrounds the area,
forming an adhesion layer (34) comprising a second metallic material above a cover body (36),
applying a liquid first alloy (32) having a melting point in the range between -20°C and 100°C in the area on the first optoelectronic layer structure and/or on the adhesion layer (34) of the cover body (36),
coupling the cover body (36) with the optoelectronic layer structure such that the adhesion layer (34) is coupled with the frame structure (30) and that the liquid first alloy (32) is in direct physical contact with the adhesion layer (34) and the frame structure (30), and
at least a part of the first alloy (32) is chemically reacting with the metallic materials of the frame structure (30) and the adhesion layer (34), whereby at least a second alloy (33) is formed, which solidifies and as such fixes the cover body (36) to the optoelectronic layer structure.

2. A method according to claim 1, wherein the melting point of the first alloy (32) is in the range between 0°C and 80°C, in particular between 20°C and 30°C.

3. A method according to claim 2, wherein the first alloy (32) is liquid at room temperature.

4. A method according to one of the preceding claims, wherein the first alloy (32) comprises gallium, indium, tin, copper, molybdenum, silver, and/or bismuth.

5. A method according to one of the preceding claims, wherein the first and/or the second metallic material comprises aluminum, zinc, chromium, copper, molybdenum, silver, gold, nickel, gallium, indium, and/or tin.

6. A method according to one of the preceding claims, wherein the optoelectronic layer structure comprises an encapsulation layer (28) and wherein the frame structure (30) is formed on the encapsulation layer (28).

7. A method according to one of the preceding claims, wherein a first anti-adhesion layer is at least sectionally formed laterally neighboring the frame structure (30), with the material of anti-adhesion layer not chemically reacting with the first alloy (32) and/or with the anti-adhesion layer not being wetted by the first alloy (32).

8. A method according to one of the preceding claims, wherein a second anti-adhesion layer laterally neighboring the adhesion layer (34) is formed above the cover body (36), with the material of second anti-adhesion layer not chemically reacting with the first alloy (32) and/or with the second anti-adhesion layer not being wetted by the first alloy (32).

9. An optoelectronic component (10), comprising
a carrier (12),
an optoelectronic layer structure having a functional layer structure (22) above the carrier (12),
a frame structure (30) comprising a first metallic material above the optoelectronic layer structure, wherein an area above the functional layer structure (22) is exposed by the frame structure (30) and the frame structure (30) surrounds the area,
a cover body having an adhesion layer (34) comprising a second metallic material and being coupled with the frame structure (30),
a liquid first alloy (32) having a melting point in the range between -20°C and 100°C and being formed in the area on the optoelectronic layer structure, and
a second liquid alloy (33) being formed by a chemical reaction of the first alloy (32) with the metallic materials of the frame structure (30) and the adhesion layer (34), wherein the second alloy is solidified and fixes the cover body (36) to the optoelectronic layer structure.

10. An optoelectronic component (10) according to claim 9, wherein the melting point of the first alloy (32) is in the range between 0°C and 80°C, in particular between 20°C and 30°C.

11. An optoelectronic component (10) according to claim 10, wherein the first alloy (32) is liquid at room temperature.

12. An optoelectronic component (10) according to one of claims 9 to 11, wherein the first alloy (32) comprises gallium, indium, tin, and/or bismuth.

13. An optoelectronic component (10) according to one of claims 9 to 12, wherein the first and/or the second metallic material comprises aluminum and/or zinc.

14. An optoelectronic component (10) according to one of claims 9 to 13, wherein the optoelectronic layer structure comprises an encapsulation layer (28) and wherein the frame structure (30) is formed on the encapsulation layer (28).

## Revendications

1. Procédé de fabrication d'un composant optoélectronique (10), procédé dans lequel
- une structure de couche optoélectronique pourvue d'une structure de couche fonctionnelle (22) est formée sur un support (12),
- une structure de cadre (30) pourvue d'un premier matériau métallique est formée sur la structure de couche optoélectronique de sorte qu'une zone située au-dessus de la structure de couche fonctionnelle (22) soit dépourvue de la structure de cadre (30) et que la structure de cadre (30) entoure la zone,
- une couche adhésive (34) pourvue d'un deuxième matériau métallique est formée sur un corps de recouvrement (36),
- un premier alliage liquide (32), dont le point de fusion est compris entre -20 °C et 100 °C, est appliqué dans la zone sur la première structure de couche optoélectronique et/ou la couche adhésive (34) du corps de recouvrement (36),
- le corps de recouvrement (36) est couplé à la structure de couche optoélectronique de sorte que la couche adhésive (34) soit couplée à la structure de cadre (30) et que le premier alliage liquide (32) soit en contact physique avec la couche adhésive (34) et la structure de cadre (30), et
- au moins une partie du premier alliage (32) réagit chimiquement avec les matériaux métalliques de la structure de cadre (30) et de la couche adhésive (34), ce qui forme au moins un deuxième alliage (33) qui se solidifie et relie ainsi le corps de recouvrement (36) solidement à la structure de couche optoélectronique.

2. Procédé selon la revendication 1, dans lequel le point de fusion du premier alliage (32) est compris entre 0 °C et 80 °C, en particulier entre 20 °C et 30 °C.

3. Procédé selon la revendication 2, dans lequel le premier alliage (32) est liquide à la température ambiante.

4. Procédé selon l'une des revendications précédentes, dans lequel le premier alliage (32) comprend du gallium, de l'indium, de l'étain, du cuivre, du molybdène, de l'argent et/ou du bismuth.

5. Procédé selon l'une des revendications précédentes, dans lequel le premier matériau métallique et/ou le deuxième matériau métallique comportent de l'aluminium, du zinc, du chrome, du cuivre, du molybdène, de l'argent, de l'or, du nickel, du gallium, de l'indium et/ou de l'étain.

6. Procédé selon l'une des revendications précédentes, dans lequel la structure de couche optoélectronique comprend une couche d'encapsulation (28) et dans lequel la structure de cadre (30) est formée sur la couche d'encapsulation (28).

7. Procédé selon l'une des revendications précédentes, dans lequel une première couche antiadhésive est formée latéralement de manière adjacente à la structure de cadre (30), le matériau de la première couche antiadhésive ne réagissant pas chimiquement avec le premier alliage (32) et/ou la première couche antiadhésive n'étant pas mouillée par le premier alliage (32).

8. Procédé selon l'une des revendications précédentes, dans lequel une deuxième couche antiadhésive est formée latéralement de manière adjacente à la couche adhésive (34) sur le corps de recouvrement, le matériau de la deuxième couche antiadhésive ne réagissant pas chimiquement avec le premier alliage (32) et/ou la deuxième couche antiadhésive n'étant pas mouillée par le premier alliage (32).

9. Composant optoélectronique (10), comprenant
- un support (12),
- une structure de couche optoélectronique pourvue d'une structure de couche fonctionnelle (22) sur le support (12),
- une structure de cadre (30), comportant un premier matériau métallique, sur la structure de couche optoélectronique, une zone située sur la structure de couche fonctionnelle (22) étant dépourvue de la structure de cadre (30) et la structure de cadre (30) entourant la zone.
- un corps de recouvrement pourvu d'une couche adhésive (34) comportant un deuxième matériau métallique et couplée à la structure de cadre (30),
- un premier alliage liquide (32) dont le point de fusion est compris entre -20 °C et 100 °C et qui est disposé dans la zone sur la structure de couche optoélectronique, et
- un deuxième alliage (33) résultant d'une réaction chimique du premier alliage (32) avec les matériaux métalliques de la structure de cadre (30) et de la couche adhésive (34), le deuxième alliage étant rigide et reliant le corps de recouvrement (36) solidement à la structure de couche optoélectronique.

10. Composant optoélectronique (10) selon la revendication 9, dans lequel le point de fusion du premier alliage (32) est compris entre 0 ° et 80 °C, en particulier entre 20 °C et 30 °C.

11. Composant optoélectronique (10) selon la revendication 10, dans lequel le premier alliage (32) est liquide à la température ambiante.

12. Composant optoélectronique (10) selon l'une des revendications 9 à 11, dans lequel le premier alliage (32) comprend du gallium, de l'indium, de l'étain et/ou du bismuth.

13. Composant optoélectronique (10) selon l'une des revendications 9 à 12, dans lequel le premier matériau métallique et/ou le deuxième matériau métallique comportent de l'aluminium et/ou du zinc.

14. Composant optoélectronique (10) selon l'une des revendications 9 à 13, dans lequel la structure de couche optoélectronique comporte une couche d'encapsulation (28) et dans lequel la structure de cadre (30) est formée sur la couche d'encapsulation (28).
